(19) Europäisches Patentamt
European Patent Office
Office européen des brevets

(11) **EP 3 166 153 B1**

(12) **EUROPEAN PATENT SPECIFICATION**

(45) Date of publication and mention
of the grant of the patent:
**24.10.2018  Bulletin 2018/43**

(21) Application number: **15815941.8**

(22) Date of filing: **03.07.2015**

(51) Int Cl.:
*H01L 33/64* (2010.01)          *F21V 29/00* (2015.01)
*F21V 29/60* (2015.01)          *F21V 29/80* (2015.01)
*F21Y 101/00* (2016.01)

(86) International application number:
**PCT/CN2015/083294**

(87) International publication number:
**WO 2016/000662 (07.01.2016 Gazette 2016/01)**

(54) **HEAT-DISSIPATION DEVICE OF LED**

LED-WÄRMEABLEITUNGSVORRICHTUNG

DISPOSITIF DE DISSIPATION THERMIQUE DE DEL

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **04.07.2014  CN 201410317415**

(43) Date of publication of application:
**10.05.2017  Bulletin 2017/19**

(73) Proprietor: **Zhang, Yixing
Beijing 100088 (CN)**

(72) Inventor: **Zhang, Yixing
Beijing 100088 (CN)**

(74) Representative: **Gille Hrabal
Brucknerstrasse 20
40593 Düsseldorf (DE)**

(56) References cited:
**EP-A1- 2 720 265          CN-A- 101 191 611
CN-A- 101 349 519          CN-A- 102 252 300
CN-A- 104 124 331          CN-Y- 201 277 525
US-A1- 2012 044 642          US-A1- 2012 068 206**

## Description

## Technical Field

The present invention belongs to the field of lighting electrical appliance, and specifically relates to a heat-dissipation device of an LED (Light Emitting Diode).

## Technical Background

As green lighting, the LED has a series of prominent advantages. The LED lighting industry is in a phase of explosive growth currently.

As we see, although the LED has higher luminous efficiency than other light sources, more than half of energy obtained by the LED from a power supply is still used for heating. For the LED, a small LED chip always generates a lot of heat while emitting light, and the heat will directly influence the normal operation of the LED.

With the increase of the LED power, in order to increase the heat-dissipation surface area of a radiator, the present radiator is increasingly large and heavy but with little effect. Therefore, the heat-dissipation problem of the LED has been a problem that must be preferentially considered.

## Summary of Invention

An aim of the present invention is to provide a heat-dissipation device of an LED. The weight and size of the heat-dissipation device of the LED can be reduced exponentially under the condition that a proper working temperature of the LED chip is ensured, and the ground insulation of the whole heat-dissipation device can also be ensured. A state of the art heat dissipation device is disclosed in EP2720265A1.

The present invention provides a heat-dissipation device of an LED. The device includes a large number of cylinders made of a heat conducting material. The diameters of the cylinders of the heat conducting material are less than 2mm, and the minimum diameter is more than 0.01mm; a heat-dissipation housing of an LED chip is contacted with one end of the cylinders made of the heat conducting material through the heat conducting material or in a direct manner, in order to heat the air around the cylinders, and the heat is taken away by the flowing air.

In the heat-dissipation device of the LED provided by the present invention, the diameters of the cylinders of the heat conducting material are less than 0.3mm, so that the cylinders made of the heat conducting material form one or a plurality of heat conducting material wires; the heat-dissipation housing of the LED chip is contacted with one end of the heat conducting material wires through the heat conducting material or in a direct manner, in order to transmit the heat to the heat conducting material wires and heat the air around the heat conducting material wires; and the heat is taken away by the flowing air.

Further, the heat-dissipation housing of the LED chip can be directly fused with one end of the heat conducting material wires into a whole; the LED chip directly heats the air around the heat conducting material wires through the heat conducting material wires on the heat-dissipation housing thereof, and the heat is taken away by the flowing air.

Herein, the heat conducting material may be copper; the cylinders of the heat conducting material are copper cylinders, and the heat conducting material wires are copper wires.

The surfaces of the cylinders of the heat conducting material or the heat conducting material wires can be covered by a protective layer for preventing the cylinders of the heat conducting material or the heat conducting material wires from being oxidized, corroded or polluted.

Specifically, the protective layer covering the surfaces can be a silver plating, the cylinders of the heat conducting material, covered by the protective layer on the surfaces, are silvered copper cylinders, and the heat conducting material wires covered by the protective layer on the surfaces are silvered copper wires.

In the heat-dissipation device of the LED provided by the present invention, the cylinders of the heat conducting material or the heat conducting material wires are arranged in an air flowing pipeline; a blower is connected into the pipeline, and air is circulated by means of the blower to take away heat.

The heat-dissipation device of the LED provided by the present invention may not be connected with the blower, while the cylinders of the heat conducting material or the heat conducting material wires are arranged in an air-flowing pipeline of which the outlet and the inlet have a certain height difference, air becomes light by means of heating expansion to form a pressure difference between the outlet and the inlet, and the air circulation is promoted to take away heat.

Further, the device may also include a special air-flowing pipeline for storing the heated air; the outlet and the inlet of the special air-flowing pipeline have a certain height difference, air becomes light by means of heating expansion to form a pressure difference, and the air circulation is accelerated to take away heat.

The pipeline may be made of an insulation material, in order to ensure the ground insulation of the whole heat-dissipation device.

In the heat-dissipation device of the LED provided by the present invention, aluminum profiles which are usually large and heavy are changed into some metal wires arranged in the plastic pipeline, and the heat-dissipation effect of these metal wires is not hard to see through the following simple calculation. As we know, for a cylinder having a radius of r and a height of h, its volume is as follows:

$$V=\pi r^2 h$$

its lateral area is as follows:

$$S=2\pi rh$$

Thus, for the cylinder with the same volume, the area of the cylindrical surface is inversely proportional to the radius. In this case, the surface area of a copper wire having the diameter of 0.1m is 100 times the lateral surface of a copper cylinder having the same volume and the diameter of 1cm.

Accordingly, a sufficient heat-dissipation area can be obtained with only a small amount of copper wires. In this case, the weight and size of the heat-dissipation device of the LED can be reduced exponentially under the condition that a proper working temperature of the LED chip is ensured, and the ground insulation of the whole heat-dissipation device can also be ensured. This is a fundamental change for the heat-dissipation device of the LED.

**Brief Description of the Drawings**

Fig. 1 shows an LED chip and a plurality of copper wires welded on a heat-dissipation housing of the LED chip in the present invention.
Fig. 2 is a schematic diagram of a heat-dissipation device of an LED.

**Detailed description of the Preferred Embodiment**

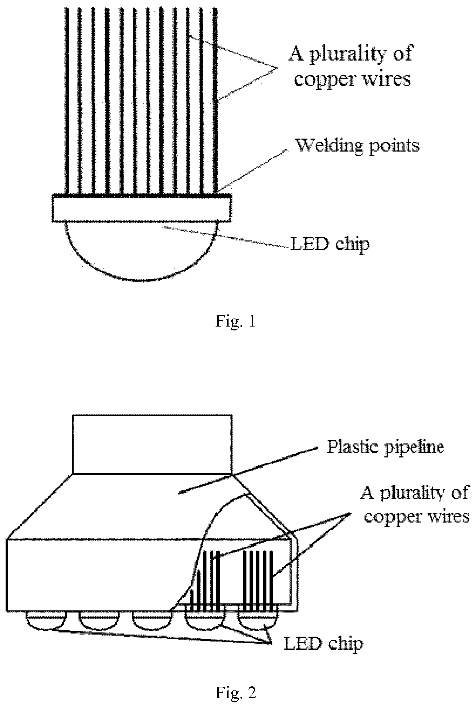

As shown in Fig. 1, as a beam of heat-conducting material wires, a plurality of copper wires are directly welded on a heat-dissipation housing of an LED chip. The heat-dissipation housing transmits heat to the copper wires, in order to heat the air around the copper wires; and the heat is taken away by the flowing air.

The surfaces of the copper wires are covered by a protective layer for preventing the cylinders of the heat conducting material from being oxidized, corroded or polluted.

The heat-dissipation housing of the LED chip can be directly fused with one end of the copper wires into a whole.

As shown in Fig. 2, a plurality of LED chips welded with a plurality of copper wires are integrated together, and are properly arranged in an air-flowing plastic pipeline.

The outlet and the inlet of the plastic pipeline have a certain height difference, air becomes light by means of heating expansion to further form a pressure difference, and air circulation is promoted to take away heat.

The pipeline is made of an insulation material, in order to ensure the ground insulation of the whole heat-dissipation device.

The LED chips are properly connected with each other and are connected to a proper driving power supply to form an LED lamp as we need.

In the heat-dissipation device of the LED provided by the present invention, aluminum profiles which are usually large and heavy are changed into some metal wires arranged in the plastic pipeline, so that the weight and size of the heat-dissipation device of the LED can be reduced exponentially under the condition that a proper working temperature of the LED chip is ensured, and the ground insulation of the whole heat-dissipation device can also be ensured.

**Claims**

1. A heat-dissipation device of an LED, wherein the device comprises a plurality of heat conducting wires, and a heat-dissipation housing of the LED chip is contacted with one end of the plurality of heat conducting wires, in order to transmit heat to the heat conducting wires and heat the air around the heat conducting wires, so that the heat can be taken away by flowing air,
**characterized in that**
each heat conducting wire is formed by several cylinders made of a heat conducting material, wherein the heat-dissipation housing of the LED chip is contacted with one end of the cylinders made of the heat conducting material through the heat conducting material or in a direct manner, in order to heat the air around the cylinders, and the heat is taken away by the flowing air, wherein the diameters of the cylinders of the heat conducting material are more than 0.01 mm and less than 0.3 mm.

2. The heat-dissipation device of the LED of claim 1, wherein the heat-dissipation housing of the LED chip is directly fused with one end of the heat conducting wires; the LED chip directly heats the air around the heat conducting wires through the heat conducting wires on the heat-dissipation housing thereof, and the heat is taken away by the flowing air.

3. The heat-dissipation device of the LED of claims 1 or 2, wherein the heat conducting material is copper; the cylinders of the heat conducting material are copper cylinders.

4. The heat-dissipation device of the LED of any one of claims 1 to 3, wherein the surfaces of the cylinders of the heat conducting material are covered by a protective layer for preventing the cylinders of the heat conducting material from being oxidized, corroded or polluted.

5. The heat-dissipation device of the LED of claim 4, wherein the protective layer covering the surfaces is a silver plating, the cylinders of the heat conducting material, covered by the protective layer on the surfaces, are silvered copper cylinders.

6. The heat-dissipation device of the LED of any one of claims 1 to 5, wherein the heat conducting material wires are arranged in an air-flowing pipeline; a blower is connected into the pipeline, and air is circulated by means of the blower to take away heat.

7. The heat-dissipation device of the LED of any one of claims 1 to 5, wherein the heat conducting material wires are arranged in an air-flowing pipeline; the outlet and the inlet of the pipeline have a certain height difference, air becomes light by means of heating expansion to form a pressure difference between the outlet and the inlet, and air circulation is promoted to take away heat.

8. The heat-dissipation device of the LED of claim 7, wherein the device further comprises a special air-flowing pipeline for storing the heated air; the outlet and the inlet of the special air flowing pipeline have a certain height difference, air becomes light by means of heating expansion to form a pressure difference, and air circulation is accelerated to take away heat.

9. The heat-dissipation device of the LED of any one of claims 6 to 8, wherein the pipeline is made of an insulation material, in order to ensure the insulation of the whole heat-dissipation device against ground.

**Patentansprüche**

1. LED-Wärmeableitungsvorrichtung, wobei die Vorrichtung eine Vielzahl von wärmeleitenden Drähten aufweist,
und wobei ein Wärmeableitungsgehäuse des LED-Chips mit einem Ende der Vielzahl von wärmeleitenden Drähten in Kontakt gebracht wird, um Wärme auf die wärmeleitenden Drähte zu übertragen und die Luft, welche die wärmeleitenden Drähte umgibt, zu erwärmen, so dass die Wärme durch Luftströme abgeführt werden kann,
**dadurch gekennzeichnet, dass**
jeder wärmeleitender Draht aus mehreren Zylindern aus einem wärmeleitenden Material gebildet ist, wobei das Wärmeableitungsgehäuse des LED-Chips mit einem Ende der Zylinder aus wärmeleitendem Material durch das wärmeleitende Material oder in direkter Weise in Kontakt gebracht wird, um die Luft, welche die Zylinder umgibt, zu erwärmen, und die Wärme durch den Luftstrom abgeführt wird, wobei die Durchmesser der Zylinder aus dem wärmeleitenden Material größer als 0,01 mm und kleiner als 0,3 mm sind.

2. LED-Wärmeableitungsvorrichtung gemäß Anspruch 1, wobei das Wärmeableitungsgehäuse des LED-Chips direkt mit einem Ende der wärmeleitenden Drähte verschmolzen ist; der LED-Chip direkt die Luft, welche die wärmeleitenden Drähte umgibt, durch die wärmeleitenden Drähte an dem Wärmeableitungsgehäuse des LED-Chips erwärmt und die Wärme durch den Luftstrom abgeführt wird.

3. LED-Wärmeableitungsvorrichtung gemäß Anspruch 1 oder 2, wobei das wärmeleitende Material aus Kupfer besteht; wobei die Zylinder aus dem wärmeleitenden Material Kupferzylinder sind.

4. LED-Wärmeableitungsvorrichtung gemäß irgendeinem der Ansprüche 1 bis 3, wobei die Oberflächen der Zylinder aus dem wärmeleitenden Material von einer Schutzschicht bedeckt sind, um zu verhindern, dass die Zylinder aus dem wärmeleitenden Material oxidieren, korrodieren oder verschmutzen.

5. LED-Wärmeableitungsvorrichtung gemäß Anspruch 4, wobei die die Oberflächen abdeckende Schutzschicht aus einer Versilberung besteht, wobei die Zylinder aus dem wärmeleitenden Material, deren Oberflächen mit der Schutzschicht bedeckt sind, aus versilberten Kupferzylindern bestehen.

6. LED-Wärmeableitungsvorrichtung gemäß irgendeinem der Ansprüche 1 bis 5, wobei die Drähte aus wärmeleitendem Material in einer Luftdurchströmleitung angeordnet sind; wobei ein Gebläse an der Leitung angeschlossen ist und Luft mit Hilfe des Gebläses hindurch geblasen wird, um die Wärme abzuleiten.

7. LED-Wärmeableitungsvorrichtung gemäß irgendeinem der Ansprüche 1 bis 5, wobei die Drähte aus wärmeleitendem Material in einer Luftdurchströmleitung angeordnet sind; wobei der Auslass und der Einlass der Leitung einen bestimmten Höhenunterschied aufweisen, wobei die Luft mittels Erwärmungsausdehnung leicht wird, um einen Druckunterschied zwischen dem Auslass und dem Einlass zu bilden und wobei die Luftzirkulation zur Ableitung der Wärme befördert wird.

8. LED-Wärmeableitungsvorrichtung gemäß Anspruch 7, wobei die Vorrichtung ferner eine spezielle Luftdurchströmleitung zur Speicherung der erwärmten Luft aufweist; wobei der Auslass und der Einlass der speziellen Luftdurchströmleitung einen bestimmten Höhenunterschied aufweisen, wobei die Luft mittels Erwärmungsausdehnung leicht wird, um einen Druckunterschied zu bilden und wobei die Luftzirkulation zur Ableitung der Wärme beschleunigt wird.

9. LED-Wärmeableitungsvorrichtung gemäß irgendeinem der Ansprüche 6 bis 8, wobei die Leitung aus einem Isoliermaterial besteht, um die Isolierung der gesamten Wärmeableitungsvorrichtung gegenüber dem Untergrund sicherzustellen.

**Revendications**

1. Dispositif de dissipation de chaleur d'une LED, dans lequel le dispositif comprend une pluralité de fils conducteurs de chaleur,
   et un boîtier de dissipation de chaleur de la puce LED étant mis en contact avec une extrémité de la pluralité de fils conducteurs de chaleur pour transmettre de la chaleur aux fils conducteurs de chaleur et chauffer l'air autour des fils conducteurs de chaleur, de sorte que la chaleur peut être emportée par le courant d'air,
   **caractérisé en ce que**
   chaque fil conducteur de chaleur est formé par plusieurs cylindres fabriqués en un matériau conducteur de chaleur,
   dans lequel le boîtier de dissipation de chaleur de la puce LED est mis en contact avec une extrémité des cylindres fabriqués en le matériau conducteur de chaleur à travers le matériau conducteur de chaleur ou d'une manière directe pour chauffer l'air autour des cylindres, et la chaleur est emportée par le courant d'air,
   dans lequel les diamètres des cylindres en matériau conducteur de chaleur sont plus grands que 0,01 mm et plus petits que 0,3 mm.

2. Dispositif de dissipation de chaleur de la LED selon la revendication 1, dans lequel le boîtier de dissipation de chaleur de la puce LED est directement fusionné avec une extrémité des fils conducteurs de chaleur ; la puce LED chauffe directement l'air autour des fils conducteurs de chaleur à travers les fils conducteurs de chaleur sur son boîtier de dissipation de chaleur et la chaleur est emportée par le courant d'air.

3. Dispositif de dissipation de chaleur de la LED selon la revendication 1 ou la revendication 2, dans lequel le matériau conducteur de chaleur est du cuivre et les cylindres en matériau conducteur de chaleur sont des cylindres en cuivre.

4. Dispositif de dissipation de chaleur de la LED selon l'une quelconque des revendications 1 à 3, dans lequel les surfaces des cylindres en matériau conducteur de chaleur sont couvertes par une couche de protection pour empêcher les cylindres en matériau conducteur de chaleur d'être oxydés, corrodés ou pollués.

5. Dispositif de dissipation de chaleur de la LED selon la revendication 4, dans lequel la couche de protection, qui couvre les surfaces, est un placage argent, et les cylindres en matériau conducteur de chaleur, dont les surfaces sont couvertes par la couche de protection, sont des cylindres en cuivre argentés.

6. Dispositif de dissipation de chaleur de la LED selon l'une quelconque des revendications 1 à 5, dans lequel les fils en matériau conducteur de chaleur sont disposés dans une conduite de flux d'air ; un souffleur est raccordé à la conduite et de l'air est circulé par moyen du souffleur pour emporter la chaleur.

7. Dispositif de dissipation de chaleur de la LED selon l'une quelconque des revendications 1 à 5, dans lequel les fils en matériau conducteur de chaleur sont disposés dans une conduite de flux d'air ; la sortie et l'entrée de la conduite ayant une certaine différence de hauteur, l'air devenant léger grâce à l'expansion de chauffage pour former une différence de pression entre la sortie et l'entrée et la circulation d'air étant promue pour évacuer de la chaleur.

8. Dispositif de dissipation de chaleur de la LED selon la revendication 7, dans lequel le dispositif comprend en outre une conduite de flux d'air particulière pour stocker l'air chauffé ; la sortie et l'entrée de la conduite de flux d'air particulière ayant une certaine différence de hauteur, l'air devenant léger grâce à l'expansion de chauffage pour former une différence de pression et la circulation d'air étant accélérée pour évacuer de la chaleur.

9. Dispositif de dissipation de chaleur de la LED selon l'une quelconque des revendications 6 à 8, dans lequel la conduite est fabriquée en un matériau isolant pour assurer l'isolation du dispositif de dissipation de chaleur entier contre le sol.

Fig. 1

Fig. 2

**EP 3 166 153 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2720265 A1